# EUROPEAN PATENT SPECIFICATION

(11) **EP 2 658 101 B1**
(45) Date of publication and mention of the grant of the patent: **14.11.2018**
(21) Application number: 13165239.8
(22) Date of filing: 24.04.2013
(51) Int. Cl.: H02K 5/14, H02K 11/20, H02K 11/25, G01R 31/327, G01R 31/34, G01R 31/12, H02K 13/00, H01R 39/58, H01H 9/50

(54) **Alternator, preferably for an electric power plant, and method for monitoring the conditions of at least one sliding contact of an alternator**
Generator, vorzugsweise für Stromerzeugung, und Verfahren zur Überwachung von mindestens einer Generatorschleifkontakt
Alternateur, de préférence pour centrale électrique, et procédé de surveillance de l'état d'au moins un contact électrique glissant d'un alternateur

(30) Priority: 24.04.2012 IT MI20120688
(43) Date of publication of application: 30.10.2013
(73) Proprietor: Ansaldo Energia S.p.A., Genova (IT)
(72) Inventor: D'agostino, Fabrizio, 16143 GENOVA (IT); Di Liddo, Sergio, 16142 GENOVA (IT); Botto, Guido, 16039 SESTRI LEVANTE (IT); Verrecchia, Paolo, 16035 RAPALLO (IT)
(74) Representative: Boggio, Luigi

(56) References cited:
- EP-A1- 2 166 649
- WO-A1-2010/015269
- DE-A1- 19 932 024
- GB-A- 2 461 533
- US-A1- 2007 063 859
- US-A1- 2011 320 169

## Description

The present invention relates to an alternator, preferably for an electric power plant, and to a method for monitoring the conditions of at least one sliding contact of an alternator.

The electric power plants usually comprise at least one rotating turbine (of steam and/or gas type), which drives an alternator, configured to produce electric power.

The alternators of known type extend along a longitudinal axis and are provided with a fixed part, the stator, and a movable part, the rotor.

The rotor is housed inside the stator and is supported by two bearings, which are keyed to the rotating shaft of the alternator.

The rotor thus configured is driven by the turbine.

The rotor is configured so as to generate a rotating magnetic field that induces an electromotive force in the stator and is provided with electrical windings. The electrical windings of the rotor are supplied with a supply current by way of a collector assembly, which receives the electrical current from an excitation system and transmits the same to the electrical windings of the rotor.

The collector assembly is configured to transmit the current coming from the outside to the electrical windings of the rotor and is provided with a plurality of sliding contacts, made by means of brushes, preferably made of graphite.

In use, a thin conductive film is formed on the brushes due to the presence of coal dust (produced by the same brushes) and of moisture from the atmosphere.
When the conductive film does not have optimal current conduction properties, dangerous phenomena of electrical sparking occurs. The electrical sparking may cause a premature wear of the brushes and of the insulating elements increasing the likelihood of failure and consequent stoppage of the electric power plant. Known methods for monitoring the wear of the brushes and the occurrence of electrical sparking are disclosed in US2011/32Q169, GB2461533, DE19932024, US2007/063859**,** EP2166649, WO2010/015269. However these methods are not sufficiently reliable.
It is therefore an object of the present invention to provide an alternator being simple, economical, and reliable at the same time. In particular, it is an object of the present invention to provide an alternator in which the conditions of the sliding contacts are monitored in real time in order to prevent irreversible damage to the collector assembly.
In accordance with said objects, the present invention relates to an alternator according to claim 1.

It is a further object of the present invention to provide a method for monitoring the conditions of at least one sliding contact of an alternator being simple, economical, and at the same time able to prevent irreversible damage to the collector assembly.
In accordance with said objects, the present invention relates to a method for monitoring the conditions of at least one sliding contact of an alternator according to claim 14. Further characteristics and advantages of the present invention will become clear from the following description of one of its non-limiting embodiments, with reference to the accompanying drawings, wherein:
- Figure 1 is a schematic side view of an alternator, preferably of an electric power plant, comprising the monitoring device according to the present invention;
- Figure 2 is a schematic side view, with parts in section and parts removed for clarity, of a detail of the alternator of Figure 1.
- Figure 3 is a schematic front view, with parts in section and parts removed for clarity, of the detail of figure 2.

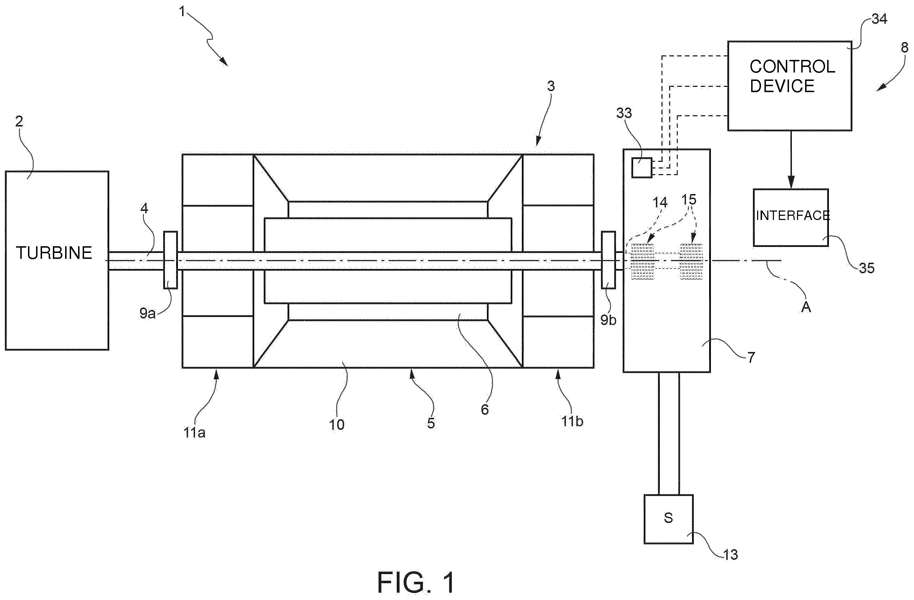

In figure 1 is indicated with the reference number 1 an electric power plant comprising a rotating turbine 2 (shown schematically in Figure 1) and an alternator 3, which is driven by the turbine 2 and is configured to transform the rotation motion imposed by the turbine 2 into electric power.

The alternator 3 extends along a longitudinal axis A and comprises a shaft 4 connected to the turbine 2, a stator 5, a rotor 6, a collector assembly 7 and a monitoring device 8.

The stator 5 represents the fixed unit and comprises a cylindrical core 10 and two opposite heads 11a and 11b and a plurality of stator bars (not visible in the attached figures). The head 11a is arranged between the core 10 and the turbine 2.

The core 10 is provided with a plurality of axial recesses (not visible in the attached figures). Each stator bar extends along a first portion substantially parallel to the axis A and to a respective internal axial recess of the core 10 and along two portions in correspondence to the heads 11.

The rotor 6 is housed inside the stator 5 and rotates driven by the turbine 2.

In particular, the rotor 6 is supported by a first bearing 9a and a second bearing 9b, which are keyed to the shaft 4.
The first bearing 9a is arranged between the stator 5 and the collector assembly 7, while the second bearing 9b is arranged between the stator 5 and the turbine 2.

The rotor 6 is configured so as to generate a rotating magnetic field that induces an electromotive force in the stator 5.

In detail, the rotor 6 comprises a rotor winding provided with a plurality of electromagnets (not visible in the attached figures), which are generally defined as rotor winding bars.

The electromagnets of the rotor 6 are supplied with a supply current by way of the collector assembly 7, which receives the electrical current from an external source 13 (shown schematically in Figure 1) and transmits it to the electromagnets of the rotor 6. Generally the external source 13 is defined by an excitation system.

The collector assembly 7 is arranged near the head 11b and extends around an end portion 14 of the shaft 4, which is provided with two collector rings 15.

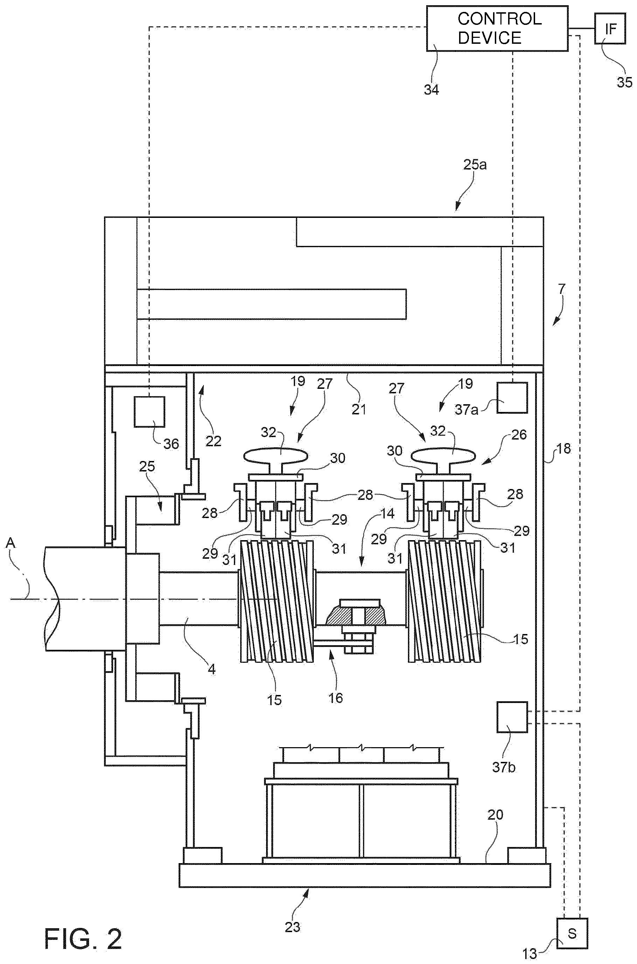

With reference to Figure 2, each collector ring 15 is connected to one or more respective electromagnets by means of a respective connecting element 16 (only one of the connecting elements 16 is visible in Figure 2).

The collector assembly 7 comprises a chamber 18 and two connecting elements 19, which are arranged inside the chamber 18 and are configured to electrically connect the external source 13 with the respective collector rings 15 of the shaft 4.

The chamber 18 has a bottom wall 20, a roof 21 and two side walls 22.

The bottom wall 20 is provided with an air inlet 23 through which enters the cooling air coming from the outside of the collector 7.

The roof 21 is openable and has an opening 25 through which the cooling air that is heated while passing through the chamber 18 flows. Preferably, the opening 25 is provided with a silencer filter (not visible in the attached figures).

The opening 25 is preferably connected to an open cooling circuit 25a outside the chamber 18.

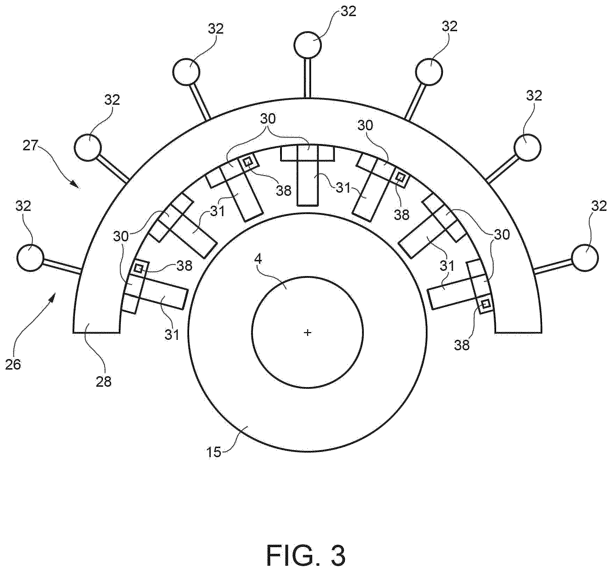

With reference to Figure 3, each connecting element 19 comprises a support frame 26 and a plurality of sliding contacts 27 fixed to the support frame 26.

The support frame 26 is defined by two plates 28 conformed as half-rings and coupled together by a plurality of uprights 29 arranged at predefined distances (not visible in the attached figures).

The support frame 26 thus defined is fixed to the side walls of the chamber 18 by means of bolts (not illustrated in the attached figures). A variant provides that the support frame 26 is fixed to a metal bulkhead that houses the blower (not shown for simplicity in the attached figures) of the cooling circuit 25a.
In particular, the support frame 26 is fixed so that the sliding contacts 27 of each connecting element 19 are arranged in contact with the respective collector ring 15.

Each sliding contact 27 is defined by a brush holder 30 and by one or more brushes 31 coupled to the brush holder 30.

The brush holder 30 is coupled, in use, to the support frame 26.

In particular, the brush holders 30 are coupled to the frame 26 so that the brushes 31 define alongside one to the other a substantially annular contact surface, adapted to slide against the outer surface of the respective collector ring 15.

Each brush holder 30 is provided with a grip handle 32, which would facilitate the assembly and disassembly of the sliding contacts 27 from the support frame 26 and speed up the ordinary and extraordinary maintenance operations.

In the non-limiting example here described and illustrated, each sliding contact 28 comprises two brushes 31.

Preferably, the brushes 31 are made of graphite.

With reference to Figure 1, the monitoring device 8 comprises a detecting sensor assembly 33 (shown schematically in Figure 1), a control device 34 and an interface 35.

With reference to Figure 2, the sensors assembly 33 comprises:
- a temperature sensor 36; preferably the temperature sensor 36 is arranged near the opening 25 through which flows the cooling air that is heated while passing through the chamber 18. A variant not shown provides that the sensors assembly 33 comprises two temperature sensors arranged inside the chamber 18; preferably, the two temperature sensors are arranged respectively along opposite inner walls of the chamber 18.
- two ozone concentration sensors 37a 37b arranged inside the chamber 18; preferably, the two ozone concentration sensors 37a 37b are respectively arranged in the lower portion (comprised between the bottom wall 20 and the shaft 4) of the chamber 18 and in the upper portion (comprised between the shaft 4 and the roof 21) of the chamber 18;
- a plurality of photo detectors 38 arranged within the chamber 18 and configured to detect the intensity and the frequency of the light events occurring inside the chamber 18; in the non-limiting example here described and illustrated the photo detectors 38 are coupled to one or more brush holders 30 so as to detect the light events (sparks) that occur between the brushes 31 and the respective collector ring 15.

In the non-limiting example of Figure 3, the photo detectors 38 are represented schematically and are coupled to a brush holder 30 every two brush holders 30.

A variant not shown provides that the photo detectors are coupled to one of the plates 28 of the support frame 26. This variant is preferably provided when the photo detectors are mounted on machines of new construction.

The control device 34 is configured to determine the operating state of at least one sliding contact 27 on the basis of the data detected by the sensor assembly 33.

In particular, the control device 34 is configured to determine an operating state of at least one sliding contact 27 chosen between at least two of the following states:
- correct operating state;
- first incorrect operating state;
- second incorrect operating state;
- third incorrect operating state;
- fourth incorrect operating state.

The control device 34 is also configured to signal by means of the interface 35, the operating state determined, so that the operator can act promptly and resolve any malfunction problems.

In detail, the control device 34 is configured to determine the correct operating state when the following conditions are met:
- the temperature detected by the temperature sensor 36 is below a first temperature threshold;
- the detected ozone concentration by at least one of the ozone concentration sensors 37a 37b is lower than the first concentration threshold;
- the intensity and the frequency of the light events detected by all the photo detectors 38 are substantially equal to zero.

The control device 34 determines the first incorrect operating state (WARNING 1) when the following conditions are met:
- the temperature detected by the temperature sensor 36 is lower than the first temperature threshold;
- the ozone concentration detected by at least one of the ozone concentration sensors 37a 37b is lower than the first concentration threshold;
- the intensity and the frequency of the light events detected by at least one photo detector 38 are different from zero and lower, respectively, to a first intensity threshold; and to a first frequency threshold.

The control device 34 determines the second incorrect operating state (WARNING 2) when the following conditions are met:
- the temperature detected by the temperature sensor 36 is lower than the first temperature threshold;
- the detected ozone concentration by at least one of the ozone concentration sensors 37a 37b is comprised between the first concentration threshold and a second concentration threshold;
- the intensity of the light events is comprised between the first intensity threshold and a second intensity threshold and the frequency of the light events is comprised between the first frequency threshold and a second frequency threshold.

The control device 34 determines the third incorrect operating state (WARNING 3) when the following conditions are met:
- the temperature detected by the temperature sensor 36 is comprised between the first temperature threshold and a second temperature threshold;
- the ozone concentration detected by at least one of the ozone concentration sensors 37a 37b is comprised between the first concentration threshold and the second concentration threshold;
- the intensity of the light events is comprised between the first intensity threshold and a second intensity threshold; and the frequency of the light events is comprised between the first frequency threshold and a second frequency threshold.

The control device 34 determines the fourth incorrect operating state (WARNING 4) when the following conditions are met:
- the temperature detected by the temperature sensor 36 is greater than the second temperature threshold;
- the ozone concentration detected by at least one of the ozone concentration sensors 37a 37b is greater than the second concentration threshold;
- the intensity of the light events is greater than the second intensity threshold and the frequency of the light events is greater than the second frequency threshold.

The first temperature threshold, the second temperature threshold, the first concentration threshold, the second concentration threshold, the first intensity threshold, the second intensity threshold, the first frequency threshold and the second frequency threshold are determined during the tuning step of the control device 34 based on the type of machine.

The number of incorrect operating states may vary depending on the needs and the type of machine on which the monitoring device 8 is mounted.

Preferably, the control device 34 comprises a memory unit (not illustrated in the attached figures) in which all the acquired data are stored. This memory unit is accessible by the operator by means of the interface 35. In this way the operator can consult the history of the data acquired for further diagnostic evaluations.

Advantageously, the monitoring device 8 of the alternator 3 according to the present invention performs a continuous monitoring of the sliding contacts 27, increasing the reliability of the alternator 3.

If the monitoring device 8 identifies an incorrect operating state of the sliding contacts 27, the operator, alerted by way of the interface 35, can, depending of the malfunction severity, program one or more maintenance interventions or even block the plant 1 before irreversible damage to the plant 1 itself can be caused.

Advantageously, the monitoring device 8 of the alternator 3 according to the present invention uses a plurality of sensors by which it is possible to make a reliable diagnosis of the sliding contacts 27, while avoiding false positives and/or false negatives. The use of monitoring parameters such as the temperature, the ozone concentration, the intensity and the frequency of the light events guarantee a fast and reliable diagnosis.

Finally, it is evident that the alternator and the monitoring method described herein may be subject to modifications and variations without departing from the scope of the appended claims.

## Claims

1. Alternator, preferably for an electric power plant (1), extending along a longitudinal axis (A) and comprising a stator (5), a rotor (6), which is housed inside the stator (5) and is provided with a shaft (4) and with a plurality of electrical windings, and a collector assembly (7), which is configured to supply current to the electrical windings of the rotor (6) and is provided with a chamber (18) and at least one sliding contact (27) housed inside the chamber (18); the alternator (3) comprising a monitoring device (8) for monitoring the conditions of at least one sliding contact (27) comprising:
- at least one first ozone concentration sensor (37a, 37b) arranged in the chamber (18);
- at least one first photo detector (38), configured to detect the intensity and the frequency of light events occurring inside the chamber (18);
the alternator being **characterized by** comprising:
- at least one first temperature sensor (36) arranged in the chamber (18);;
- a control device (34) configured to determine at least one operating state of at least one sliding contact (27) selected between a correct operating state and at least a first incorrect operating state on the basis of the data detected by the first temperature sensor (36), by the first ozone concentration sensor (37a, 37b) and by the first photo detector (38).

2. Alternator according to claim 1, wherein the control device (34) is configured to signal the operating state of the sliding contact (27) by means of an interface (35).

3. Alternator according to anyone of the foregoing Claims, wherein the control device (34) is configured to determine a correct operating state of the sliding contact (27) when the detected temperature is lower than the first temperature threshold, the detected ozone concentration is lower than the first concentration threshold, and the intensity and the frequency of the light events are substantially equal to zero.

4. Alternator according to claim 3, wherein the control device (34) is configured to determine a first incorrect operating state of the sliding contact (27) when the detected temperature is lower than the first temperature threshold, the detected ozone concentration is lower than the first concentration threshold, and the intensity and the frequency of the light events are lower respectively than a first intensity threshold and than a first frequency threshold.

5. Alternator according to claim 4, wherein the control device (34) is configured to determine a second incorrect operating state of the sliding contact (27) when the detected temperature is lower than the first temperature threshold, the detected ozone concentration is comprised between the first concentration threshold and a second concentration threshold, the intensity of the light events is comprised between the first intensity threshold and a second intensity threshold and the frequency of the light events is comprised between the first frequency threshold and a second frequency threshold.

6. Alternator according to claim 5, wherein the control device (34) is configured to determine a third incorrect operating state of the sliding contact (27) when the detected temperature is comprised between the first temperature threshold and a second temperature threshold, the detected ozone concentration is comprised between the first concentration threshold and a second concentration threshold, the intensity of the light events is comprised between the first intensity threshold and a second intensity threshold and the frequency of the light events is comprised between the first frequency threshold and a second frequency threshold.

7. Alternator according to claim 6, wherein the control device (34) is configured to determine a fourth incorrect operating state of the sliding contact (27) when the detected temperature is greater than the second temperature threshold, the detected ozone concentration is greater than the second concentration threshold, the intensity of the light events is greater than the second intensity threshold and the frequency of the light events is greater than the second frequency threshold.

8. Alternator according to anyone of the foregoing Claims, wherein at least the first temperature sensor (36), at least the first ozone concentration sensor (37a, 37b) and at least the first photo detector (38) are housed inside the chamber (18).

9. Alternator according to anyone of the foregoing Claims, wherein the first temperature sensor (36) is arranged near an opening (25) of the chamber (18) through which cooling air flows.

10. Alternator according to anyone of the foregoing Claims, wherein the monitoring device (8) comprises a plurality of photo detectors (38) arranged inside the chamber (18) .

11. Alternator according to claim 10, wherein each photo detector (38) of the plurality of photo detectors (38) are arranged substantially near one or more sliding contacts (27).

12. Alternator according to anyone of the foregoing Claims, comprising a second ozone concentration sensor (37b, 37a) arranged inside the chamber (18).

13. Alternator according to claim 12, wherein the first ozone concentration sensor (37a) is arranged in a first portion of the chamber (18) while the second ozone concentration sensor (37b) is arranged in a second portion of the chamber (18).

14. Method for monitoring the conditions of at least one sliding contact (27) of an alternator (3), preferably for an electric power plant (1); the alternator (3) extending along a longitudinal axis (A) and being provided with a stator (5), with a rotor (6), which is housed inside the stator (5) and comprises a shaft (4) and a plurality electrical windings, and a collector assembly (7), which is configured to supply current to the electrical windings of the rotor (6) and is provided with a chamber (18) and with a plurality of sliding contacts (27) housed inside the chamber (18);
the method comprising the steps of:
- detecting the ozone concentration in the chamber (18) by means of at least a first ozone concentration sensor (37a, 37b) arranged in the chamber (18);;
- detecting the frequency and the intensity of light events occurring inside the chamber (18) by means of at least a first photo detector (38);
the method being **characterized by** comprising the steps of:
- detecting the temperature of the chamber (18) by means of at least a first temperature sensor (36) arranged in the chamber (18);
- determining at least one operating state of at least a sliding contact (27) selected between a correct operating state and at least a first incorrect operating state on the basis of the data detected by first temperature sensor (36), by the first ozone concentration sensor (37a, 37b) and by the first photo detector (38).

15. Method according to claim 14, comprising the step of signaling, by means of an interface (35), the operating state of the sliding contact (27).

16. Method according to claim 14 or 15, wherein the step of determining at least one operating state of at least one sliding contact (27) comprises determine a correct operating state of the sliding contact (27) when the detected temperature is lower than a first temperature threshold, the detected ozone concentration is lower than a first concentration threshold, and the intensity and the frequency of the light events are substantially equal to zero.

17. Method according to claim 16, wherein the step of determining at least one operating state of at least a sliding contact (27) comprises determining a first incorrect operating state of the sliding contact (27) when the detected temperature is lower than the first temperature threshold, the detected ozone concentration is lower than the first concentration threshold, and the intensity and the frequency of the light events are lower respectively than a first intensity threshold and than a first frequency threshold.

18. Method according to claim 17, wherein the step of determining at least one operating state of at least a sliding contact (27) comprises determining a second incorrect operating state of the sliding contact (27) when the detected temperature is lower than the first temperature threshold, the detected ozone concentration is comprised between the first concentration threshold and a second concentration threshold, the intensity of the light events is comprised between the first intensity threshold and a second intensity threshold and the frequency of the light events is comprised between the first frequency threshold and a second frequency threshold.

19. Method according to claim 18, wherein the step of determining at least one operating state of at least a sliding contact (27) comprises determining a third incorrect operating state of the sliding contact (27) when the detected temperature is comprised between the first temperature threshold and a second temperature threshold, the detected ozone concentration is comprised between the first concentration threshold and a second concentration threshold, the intensity of the light events is comprised between the first intensity threshold and a second intensity threshold and the frequency of the light events is comprised between the first frequency threshold and a second frequency threshold.

20. Method according to claim 19, wherein the step of determining at least one operating state of at least a sliding contact (27) comprises determine a fourth incorrect operating state of the sliding contact (27) when the detected temperature is greater than the second temperature threshold, the detected ozone concentration is greater than the second concentration threshold, the intensity of the light events is greater than the second intensity threshold and the frequency of the light events greater than the second frequency threshold.

## Patentansprüche

1. Wechselstromgenerator, vorzugsweise für ein elektrisches Kraftwerk (1), der sich entlang einer Längsachse (A) erstreckt und einen Stator (5), einen Rotor (6), der in dem Stator (5) aufgenommen ist und mit einer Welle (4) und mit mehreren elektrischen Wicklungen ausgestattet ist, und eine Kollektoranordnung (7) umfasst, die konfiguriert ist, Strom an die elektrischen Wicklungen des Rotors (6) zuzuführen, und mit einer Kammer (18) und wenigstens einem Gleitkontakt (27), der in der Kammer (18) aufgenommen ist, ausgestattet ist; wobei der Wechselstromgenerator (3) eine Überwachungsvorrichtung (8) zum Überwachen der Bedingungen wenigstens eines Gleitkontaktes (27) umfasst, Folgendes umfassend:
- wenigstens einen ersten Ozonkonzentrationssensor (37a, 37b), der in der Kammer (18) angeordnet ist;
- wenigstens einen ersten Photodetektor (38), der konfiguriert ist, die Intensität und die Häufigkeit von Lichtereignissen zu erfassen, die in der Kammer (18) auftreten;
wobei der Wechselstromgenerator durch das Umfassen von Folgendem gekennzeichnet ist:
- wenigstens einem ersten Temperatursensor (36), der in der Kammer (18) angeordnet ist;
- einer Steuervorrichtung (34), die konfiguriert ist, wenigstens einen Betriebszustand wenigstens eines Gleitkontaktes (27) zu bestimmen, der zwischen einem korrekten Betriebszustand und wenigstens einem ersten inkorrekten Betriebszustand auf der Grundlage der Daten ausgewählt wird, die durch den ersten Temperatursensor (36), durch den ersten Ozonkonzentrationssensor (37a, 37b) und durch den ersten Photodetektor (38) erfasst werden.

2. Wechselstromgenerator nach Anspruch 1, wobei die Steuervorrichtung (34) konfiguriert ist, um den Betriebszustand des Gleitkontaktes (27) durch eine Schnittstelle (35) zu signalisieren.

3. Wechselstromgenerator nach einem der vorhergehenden Ansprüche, wobei die Steuervorrichtung (34) konfiguriert ist, einen korrekten Betriebszustand des Gleitkontaktes (27) zu bestimmen, wenn die erfasste Temperatur niedriger als der erste Temperaturgrenzwert ist, die erfasste Ozonkonzentration niedriger als der erste Konzentrationsgrenzwert ist und die Intensität und die Häufigkeit der Lichtereignisse im Wesentlichen Null entsprechen.

4. Wechselstromgenerator nach Anspruch 3, wobei die Steuervorrichtung (34) konfiguriert ist, einen ersten inkorrekten Betriebszustand des Gleitkontaktes (27) zu bestimmen, wenn die erfasste Temperatur niedriger als der erste Temperaturgrenzwert ist, die erfasste Ozonkonzentration niedriger als der erste Konzentrationsgrenzwert ist und die Intensität und die Häufigkeit der Lichtereignisse niedriger als ein erster Intensitätsgrenzwert beziehungsweise als ein erster Häufigkeitsgrenzwert sind.

5. Wechselstromgenerator nach Anspruch 4, wobei die Steuervorrichtung (34) konfiguriert ist, einen zweiten inkorrekten Betriebszustand des Gleitkontaktes (27) zu bestimmen, wenn die erfasste Temperatur niedriger als der erste Temperaturgrenzwert ist, die erfasste Ozonkonzentration zwischen dem ersten Konzentrationsgrenzwert und einem zweiten Konzentrationsgrenzwert enthalten ist, die Intensität der Lichtereignisse zwischen dem ersten Intensitätsgrenzwert und einem zweiten Intensitätsgrenzwert enthalten ist und die Häufigkeit der Lichtereignisse zwischen dem ersten Häufigkeitsgrenzwert und einem zweiten Häufigkeitsgrenzwert enthalten ist.

6. Wechselstromgenerator nach Anspruch 5, wobei die Steuervorrichtung (34) konfiguriert ist, einen dritten inkorrekten Betriebszustand des Gleitkontaktes (27) zu bestimmen, wenn die erfasste Temperatur zwischen dem ersten Temperaturgrenzwert und einem zweiten Temperaturgrenzwert enthalten ist, die erfasste Ozonkonzentration zwischen dem ersten Konzentrationsgrenzwert und einem zweiten Konzentrationsgrenzwert enthalten ist, die Intensität der Lichtereignisse zwischen dem ersten Intensitätsgrenzwert und einem zweiten Intensitätsgrenzwert enthalten ist und die Häufigkeit der Lichtereignisse zwischen dem ersten Häufigkeitsgrenzwert und einem zweiten Häufigkeitsgrenzwert enthalten ist.

7. Wechselstromgenerator nach Anspruch 6, wobei die Steuervorrichtung (34) konfiguriert ist, einen vierten inkorrekten Betriebszustand des Gleitkontaktes (27) zu bestimmen, wenn die erfasste Temperatur größer als der zweite Temperaturgrenzwert ist, die erfasste Ozonkonzentration größer als der zweite Konzentrationsgrenzwert ist, die Intensität der Lichtereignisse größer als der zweite Intensitätsgrenzwert ist und die Häufigkeit der Lichtereignisse größer als der zweite Häufigkeitsgrenzwert ist.

8. Wechselstromgenerator nach einem der vorhergehenden Ansprüche, wobei wenigstens der erste Temperatursensor (36), wenigstens der erste Ozonkonzentrationssensor (37a, 37b) und wenigstens der erste Photodetektor (38) in der Kammer (18) aufgenommen sind.

9. Wechselstromgenerator nach einem der vorhergehenden Ansprüche, wobei der erste Temperatursensor (36) nahe einer Öffnung (25) der Kammer (18) angeordnet ist, durch die Kühlluft strömt.

10. Wechselstromgenerator nach einem der vorhergehenden Ansprüche, wobei die Überwachungsvorrichtung (8) mehrere Photodetektoren (38) umfasst, die in der Kammer (18) angeordnet sind.

11. Wechselstromgenerator nach Anspruch 10, wobei jeder Photodetektor (38) der mehreren Photodetektoren (38) im Wesentlichen nahe einem oder mehreren Gleitkontakten (27) angeordnet ist.

12. Wechselstromgenerator nach einem der vorhergehenden Ansprüche, einen zweiten Ozonkonzentrationssensor (37b, 37a) umfassend, der in der Kammer (18) angeordnet ist.

13. Wechselstromgenerator nach Anspruch 12, wobei der erste Ozonkonzentrationssensor (37a) in einem ersten Abschnitt der Kammer (18) angeordnet ist, während der zweite Ozonkonzentrationssensor (37b) in einem zweiten Abschnitt der Kammer (18) angeordnet ist.

14. Verfahren zum Überwachen der Bedingungen wenigstens eines Gleitkontaktes (27) eines Wechselstromgenerators (3), vorzugsweise für ein elektrisches Kraftwerk (1); wobei sich der Wechselstromgenerator (3) entlang einer Längsachse (A) erstreckt und mit einem Stator (5), mit einem Rotor (6), der in dem Stator (5) aufgenommen ist und eine Welle (4) und mehrere elektrische Wicklungen umfasst, und einer Kollektoranordnung (7) ausgestattet ist, die konfiguriert ist, Strom an die elektrischen Wicklungen des Rotors (6) zuzuführen, und mit einer Kammer (18) und mehreren Gleitkontakten (27), die in der Kammer (18) aufgenommen sind, ausgestattet ist;
wobei das Verfahren die folgenden Schritte umfasst:
- Erfassen der Ozonkonzentration in der Kammer (18) durch wenigstens einen ersten Ozonkonzentrationssensor (37a, 37b), der in der Kammer (18) angeordnet ist;;
- Erfassen der Häufigkeit und der Intensität von Lichtereignissen, die in der Kammer (18) auftreten, durch wenigstens einen ersten Photodetektor (38);
wobei das Verfahren durch das Umfassen der folgenden Schritte gekennzeichnet ist:
- Bestimmen der Temperatur der Kammer (18) durch wenigstens einen ersten Temperatursensor (36), der in der Kammer (18) angeordnet ist;
- Bestimmen wenigstens eines Betriebszustands wenigstens eines Gleitkontaktes (27), der zwischen einem korrekten Betriebszustand und wenigstens einem ersten inkorrekten Betriebszustand auf der Grundlage der Daten ausgewählt wird, die durch den ersten Temperatursensor (36), durch den ersten Ozonkonzentrationssensor (37a, 37b) und durch den ersten Photodetektor (38) erfasst werden.

15. Verfahren nach Anspruch 14, umfassend den Schritt des Signalisierens des Betriebszustandes des Gleitkontaktes (27) durch eine Schnittstelle (35).

16. Verfahren nach Anspruch 14 oder 15, wobei der Schritt des Bestimmens wenigstens eines Betriebszustands wenigstens eines Gleitkontaktes (27) das Bestimmen eines korrekten Betriebszustandes des Gleitkontaktes (27) umfasst, wenn die erfasste Temperatur niedriger als ein erster Temperaturgrenzwert ist, die erfasste Ozonkonzentration niedriger als ein erster Konzentrationsgrenzwert ist und die Intensität und die Häufigkeit der Lichtereignisse im Wesentlichen Null entsprechen.

17. Verfahren nach Anspruch 16, wobei der Schritt des Bestimmens wenigstens eines Betriebszustands wenigstens eines Gleitkontaktes (27) das Bestimmen eines ersten inkorrekten Betriebszustandes des Gleitkontaktes (27) umfasst, wenn die erfasste Temperatur niedriger als der erste Temperaturgrenzwert ist, die erfasste Ozonkonzentration niedriger als der erste Konzentrationsgrenzwert ist und die Intensität und die Häufigkeit der Lichtereignisse niedriger als ein erster Intensitätsgrenzwert beziehungsweise als ein erster Häufigkeitsgrenzwert sind.

18. Verfahren nach Anspruch 17, wobei der Schritt des Bestimmens wenigstens eines Betriebszustands wenigstens eines Gleitkontaktes (27) das Bestimmen eines zweiten inkorrekten Betriebszustands des Gleitkontaktes (27) umfasst, wenn die erfasste Temperatur niedriger als der erste Temperaturgrenzwert ist, die erfasste Ozonkonzentration zwischen dem ersten Konzentrationsgrenzwert und einem zweiten Konzentrationsgrenzwert enthalten ist, die Intensität der Lichtereignisse zwischen dem ersten Intensitätsgrenzwert und einem zweiten Intensitätsgrenzwert enthalten ist und die Frequenz der Lichtereignisse zwischen dem ersten Frequenzgrenzwert und einem zweiten Frequenzgrenzwert enthalten ist.

19. Verfahren nach Anspruch 18, wobei der Schritt des Bestimmens wenigstens eines Betriebszustands wenigstens eines Gleitkontaktes (27) das Bestimmen eines dritten inkorrekten Betriebszustands des Gleitkontaktes (27) umfasst, wenn die erfasste Temperatur zwischen dem ersten Temperaturgrenzwert und einem zweiten Temperaturgrenzwert enthalten ist, die erfasste Ozonkonzentration zwischen dem ersten Konzentrationsgrenzwert und einem zweiten Konzentrationsgrenzwert enthalten ist, die Intensität der Lichtereignisse zwischen dem ersten Intensitätsgrenzwert und einem zweiten Intensitätsgrenzwert enthalten ist und die Frequenz der Lichtereignisse zwischen dem ersten Frequenzgrenzwert und einem zweiten Frequenzgrenzwert enthalten ist.

20. Verfahren nach Anspruch 19, wobei der Schritt des Bestimmens wenigstens eines Betriebszustands wenigstens eines Gleitkontaktes (27) das Bestimmen eines vierten inkorrekten Betriebszustands des Gleitkontaktes (27) umfasst, wenn die erfasste Temperatur größer als der zweite Temperaturgrenzwert ist, die erfasste Ozonkonzentration größer als der zweite Konzentrationsgrenzwert ist, die Intensität der Lichtereignisse größer als der zweite Intensitätsgrenzwert ist und die Häufigkeit der Lichtereignisse größer als der zweite Häufigkeitsgrenzwert ist.

## Revendications

1. Alternateur, de préférence pour une centrale électrique (1), s'étendant le long d'un axe longitudinal (A) et comprenant un stator (5), un rotor (6), qui est logé à l'intérieur du stator (5) et qui est pourvu d'un arbre (4) et d'une pluralité d'enroulements électriques, et un ensemble de collecteur (7), qui est configuré pour fournir du courant aux enroulements électriques du rotor (6) et qui est pourvu d'une chambre (18) et d'au moins un contact coulissant (27) logé à l'intérieur de la chambre (18) ; l'alternateur (3) comprenant un dispositif de surveillance (8) pour surveiller les conditions d'au moins un contact coulissant (27) comprenant :
- au moins un premier capteur de concentration d'ozone (37a, 37b) agencé dans la chambre (18) ;
- au moins un premier photo-détecteur (38), configuré pour détecter l'intensité et la fréquence des événements de lumière se produisant à l'intérieur de la chambre (18) ;
l'alternateur étant **caractérisé en ce qu'**il comprend :
- au moins un premier capteur de température (36) agencé dans la chambre (18) ;
- un dispositif de commande (34) configuré pour déterminer au moins un état de fonctionnement d'au moins un contact coulissant (27) sélectionné entre un état de fonctionnement correct et au moins un premier état de fonctionnement incorrect sur la base des données détectées par le premier capteur de température (36), par le premier capteur de concentration d'ozone (37a, 37b) et par le premier photo-détecteur (38).

2. Alternateur selon la revendication 1, dans lequel le dispositif de commande (34) est configuré pour signaler l'état de fonctionnement du contact coulissant (27) au moyen d'une interface (35).

3. Alternateur selon l'une quelconque des revendications précédentes, dans lequel le dispositif de commande (34) est configuré pour déterminer un état de fonctionnement correct du contact coulissant (27) lorsque la température détectée est inférieure au premier seuil de température, la concentration d'ozone détectée est inférieure au premier seuil de concentration, et l'intensité et la fréquence des événements de lumière sont sensiblement égales à zéro.

4. Alternateur selon la revendication 3, dans lequel le dispositif de commande (34) est configuré pour déterminer un premier état de fonctionnement incorrect du contact coulissant (27) lorsque la température détectée est inférieure au premier seuil de température, la concentration d'ozone détectée est inférieure au premier seuil de concentration, et l'intensité et la fréquence des événements de lumière sont respectivement inférieures à un premier seuil d'intensité et à un premier seuil de fréquence.

5. Alternateur selon la revendication 4, dans lequel le dispositif de commande (34) est configuré pour déterminer un deuxième état de fonctionnement incorrect du contact coulissant (27) lorsque la température détectée est inférieure au premier seuil de température, la concentration d'ozone détectée est comprise entre le premier seuil de concentration et un deuxième seuil de concentration, l'intensité des événements de lumière est comprise entre le premier seuil d'intensité et un deuxième seuil d'intensité et la fréquence des événements de lumière est comprise entre le premier seuil de fréquence et un deuxième seuil de fréquence.

6. Alternateur selon la revendication 5, dans lequel le dispositif de commande (34) est configuré pour déterminer un troisième état de fonctionnement incorrect du contact coulissant (27) lorsque la température détectée est comprise entre le premier seuil de température et un deuxième seuil de température, la concentration d'ozone détectée est comprise entre le premier seuil de concentration et un deuxième seuil de concentration, l'intensité des événements de lumière est comprise entre le premier seuil d'intensité et un deuxième seuil d'intensité et la fréquence des événements de lumière est comprise entre le premier seuil de fréquence et un deuxième seuil de fréquence.

7. Alternateur selon la revendication 6, dans lequel le dispositif de commande (34) est configuré pour déterminer un quatrième état de fonctionnement incorrect du contact coulissant (27) lorsque la température détectée est supérieure au deuxième seuil de température, la concentration d'ozone détectée est supérieure au deuxième seuil de concentration, l'intensité des événements de lumière est supérieure au deuxième seuil d'intensité et la fréquence des événements de lumière est supérieure au deuxième seuil de fréquence.

8. Alternateur selon l'une quelconque des revendications précédentes, dans lequel au moins le premier capteur de température (36), au moins le premier capteur de concentration d'ozone (37a, 37b) et au moins le premier photo-détecteur (38) sont logés à l'intérieur de la chambre (18).

9. Alternateur selon l'une quelconque des revendications précédentes, dans lequel le premier capteur de température (36) est agencé à proximité d'une ouverture (25) de la chambre (18) à travers laquelle de l'air de refroidissement s'écoule.

10. Alternateur selon l'une quelconque des revendications précédentes, dans lequel le dispositif de surveillance (8) comprend une pluralité de photo-détecteurs (38) agencés à l'intérieur de la chambre (18).

11. Alternateur selon la revendication 10, dans lequel chaque photo-détecteur (38) de la pluralité de photo-détecteurs (38) est agencé sensiblement à proximité d'un ou de plusieurs contacts coulissants (27).

12. Alternateur selon l'une quelconque des revendications précédentes, comprenant un deuxième capteur de concentration d'ozone (37b, 37a) agencé à l'intérieur de la chambre (18).

13. Alternateur selon la revendication 12, dans lequel le premier capteur de concentration d'ozone (37a) est agencé dans une première partie de la chambre (18), tandis que le deuxième capteur de concentration d'ozone (37b) est agencé dans une deuxième partie de la chambre (18).

14. Procédé pour surveiller les conditions d'au moins un contact coulissant (27) d'un alternateur (3), de préférence pour une centrale électrique (1) ; l'alternateur (3) s'étendant le long d'un axe longitudinal (A) et étant pourvu d'un stator (5), d'un rotor (6), qui est logé à l'intérieur du stator (5) et comprend un arbre (4) et une pluralité d'enroulements électriques, et un ensemble de collecteur (7), qui est configuré pour fournir du courant aux enroulements électriques du rotor (6) et qui est pourvu d'une chambre (18) et d'une pluralité de contacts coulissants (27) logés à l'intérieur de la chambre (18) ;
le procédé comprenant les étapes :
- de détection de la concentration d'ozone dans la chambre (18) au moyen d'au moins un premier capteur de concentration d'ozone (37a, 37b) agencé dans la chambre (18) ;
- de détection de la fréquence et de l'intensité des événements de lumière se produisant à l'intérieur de la chambre (18) au moyen d'au moins un premier photo-détecteur (38) ;
le procédé étant **caractérisé en ce qu'**il comprend les étapes :
- de détection de la température de la chambre (18) au moyen d'au moins un premier capteur de température (36) agencé dans la chambre (18) ;
- de détermination d'au moins un état de fonctionnement d'au moins un contact coulissant (27) sélectionné entre un état de fonctionnement correct et au moins un premier état de fonctionnement incorrect sur la base des données détectées par un premier capteur de température (36), par le premier capteur de concentration d'ozone (37a, 37b) et par le premier photo-détecteur (38).

15. Procédé selon la revendication 14, comprenant l'étape de signalisation, au moyen d'une interface (35), de l'état de fonctionnement du contact coulissant (27).

16. Procédé selon la revendication 14 ou 15, dans lequel l'étape de détermination d'au moins un état de fonctionnement d'au moins un contact coulissant (27) comprend la détermination d'un état de fonctionnement correct du contact coulissant (27) lorsque la température détectée est inférieure à un premier seuil de température, la concentration d'ozone détectée est inférieure à un premier seuil de concentration, et l'intensité et la fréquence des événements de lumière sont sensiblement égales à zéro.

17. Procédé selon la revendication 16, dans lequel l'étape de détermination d'au moins un état de fonctionnement d'au moins un contact coulissant (27) comprend la détermination d'un premier état de fonctionnement incorrect du contact coulissant (27) lorsque la température détectée est inférieure au premier seuil de température, la concentration d'ozone détectée est inférieure au premier seuil de concentration, et l'intensité et la fréquence des événements de lumière sont respectivement inférieures à un premier seuil d'intensité et à un premier seuil de fréquence.

18. Procédé selon la revendication 17, dans lequel l'étape de détermination d'au moins un état de fonctionnement d'au moins un contact coulissant (27) comprend la détermination d'un deuxième état de fonctionnement incorrect du contact coulissant (27) lorsque la température détectée est inférieure au premier seuil de température, la concentration d'ozone détectée est comprise entre le premier seuil de concentration et un deuxième seuil de concentration, l'intensité des événements de lumière est comprise entre le premier seuil d'intensité et un deuxième seuil d'intensité et la fréquence des événements de lumière est comprise entre le premier seuil de fréquence et un deuxième seuil de fréquence.

19. Procédé selon la revendication 18, dans lequel l'étape de détermination d'au moins un état de fonctionnement d'au moins un contact coulissant (27) comprend la détermination d'un troisième état de fonctionnement incorrect du contact coulissant (27) lorsque la température détectée est comprise entre le premier seuil de température et un deuxième seuil de température, la concentration d'ozone détectée est comprise entre le premier seuil de concentration et un deuxième seuil de concentration, l'intensité des événements de lumière est comprise entre le premier seuil d'intensité et un deuxième seuil d'intensité et la fréquence des événements de lumière est comprise entre le premier seuil de fréquence et un deuxième seuil de fréquence.

20. Procédé selon la revendication 19, dans lequel l'étape de détermination d'au moins un état de fonctionnement d'au moins un contact coulissant (27) comprend la détermination d'un quatrième état de fonctionnement incorrect du contact coulissant (27) lorsque la température détectée est supérieure au deuxième seuil de température, la concentration d'ozone détectée est supérieure au deuxième seuil de concentration, l'intensité des événements de lumière est supérieure au deuxième seuil d'intensité et la fréquence des événements de lumière est supérieure au deuxième seuil de fréquence.
